# EUROPÄISCHE PATENTSCHRIFT

(11) **EP 3 707 753 B1**
(45) Veröffentlichungstag und Bekanntmachung des Hinweises auf die Patenterteilung: **31.08.2022**
(21) Anmeldenummer: 18799498.3
(22) Anmeldetag: 05.11.2018
(51) Int. Cl.: H01L 29/778, H01L 29/423, H01L 29/20

(54) **HALBLEITERBAUELEMENT MIT EINER TRANSISTORSTRUKTUR VOM ANREICHERUNGSTYP**
SEMICONDUCTOR ELEMENT HAVING AN ENHANCEMENT-TYPE TRANSISTOR STRUCTURE
COMPOSANT À SEMI-CONDUCTEUR DOTÉ D'UNE STRUCTURE DE TRANSISTOR DU TYPE À ENRICHISSEMENT

(30) Priorität: 06.11.2017 DE 102017125803
(43) Veröffentlichungstag der Anmeldung: 16.09.2020
(73) Patentinhaber: Institut für Mikroelektronik Stuttgart, 70569 Stuttgart (DE)
(72) Erfinder: BURGHARTZ, Joachim N., 70771 Leinfelden-Echterdingen (DE); ALOMARI, Mohammed, 70569 Stuttgart (DE); ALSHAHED, Muhammad, 70567 Stuttgart (DE)
(74) Vertreter: Witte, Weller & Partner Patentanwälte mbB
(86) Internationale Anmeldenummer: PCT/EP2018/080166
(87) Internationale Veröffentlichungsnummer: WO 2019/086664

(56) Entgegenhaltungen:
- JP-A- 2010 114 219
- US-A1- 2011 266 557
- US-A1- 2013 168 687

## Beschreibung

Die vorliegende Erfindung betrifft ein Halbleiterbauelement mit einer Transistorstruktur vom Anreicherungstyp, wobei die Transistorstruktur einen Schichtaufbau besitzt, der ein Basissubstrat, eine erste Halbleiterschicht und eine zweite Halbleiterschicht aufweist, die entlang einer ersten Richtung übereinander angeordnet sind, wobei die Transistorstruktur ferner eine Sourceelektrode, eine Gateelektrode und eine Drainelektrode besitzt, die entlang einer zweiten Richtung voneinander beabstandet sind, wobei die erste Halbleiterschicht durch ein erstes Gruppe-III-Nitridmaterial gebildet wird, das auf dem Basissubstrat angeordnet ist, wobei die zweite Halbleiterschicht durch ein zweites Gruppe-III-Nitridmaterial gebildet wird, das auf der ersten Schicht angeordnet ist, wobei das erste und das zweite Gruppe-III-Nitridmaterial verschieden voneinander sind, so dass sich im Grenzbereich der ersten und zweiten Schicht ein 2D-Elektronengas bildet, wobei die erste Halbleiterschicht und die zweite Halbleiterschicht im Bereich der Gateelektrode eine Vielzahl von Löchern aufweisen, zwischen denen eine Vielzahl von Finnen mit dem ersten und dem zweiten Gruppe-III-Nitridmaterial verbleiben, und wobei die Gateelektrode eine Vielzahl von Gatefingern besitzt, die in die Löcher hineinreichen, wobei die Löcher mit den Gatefingern eine erste Lochreihe und eine zweite Lochreihe bilden, die jeweils quer zu der zweiten Richtung verlaufen und somit eine dritte Richtung definieren, wobei die Löcher der zweiten Lochreihe in der zweiten Richtung relativ zu den Löchern der ersten Lochreihe (34) versetzt sind.

Ein solches Halbleiterbauelement ist beispielsweise aus US 2013/0168687 A1 bekannt.

Die Erfindung betrifft insbesondere einen sogenannten High Electron Mobility Transistor (HEMT), d.h. einen Transistor, der aufgrund seiner Bauform und der verwendeten Materialien eine hohe Elektronenbeweglichkeit besitzt und infolgedessen kurze Schaltzeiten ermöglicht. HEM-Transistoren sind eine spezielle Bauform von sogenannten Feldeffekttransistoren. Diese besitzen zwischen der Sourceelektrode und der Drainelektrode einen Kanal, in dem ein Strom von der Sourceelektrode zur Drainelektrode fließen kann. Mithilfe einer Spannung an der Gateelektrode kann der Stromfluss durch den Kanal beeinflusst werden, insbesondere unterdrückt oder überhaupt erst ermöglicht werden. Verwendet man im Bereich zwischen der Sourceelektrode und der Drainelektrode einen Schichtaufbau aus zwei Halbleitermaterialien mit unterschiedlichen Ferminiveaus und unterschiedlich großen Bandlücken, kann sich im Grenzbereich dieser Materialien ein sogenanntes zweidimensionales Elektronengas (2DEG) bilden. Das 2D-Elektronengas kann als leitfähiger Kanal zwischen der Sourceelektrode und der Gateelektrode dienen. Die Elektronenbeweglichkeit in dem so gebildeten Kanal ist sehr hoch.

Häufig werden Aluminiumgalliumarsenid (AIGaAs) und Galliumarsenid (GaAs) als verschiedene Halbleitermaterialien für den Schichtaufbau eines HEM-Transistor verwendet. Das HEMT-Prinzip ist aber auch mit anderen Halbleiterschichten realisierbar und in der jüngeren Vergangenheit sind Materialkombinationen in den Fokus gerückt, die Galliumnitrid (GaN) und/oder andere Verbundhalbleiter mit Stickstoff und mindestens einem Element der Hauptgruppe III des Periodensystems aufweisen (nachfolgend allgemein als Gruppe-III-Nitridmaterialien bezeichnet). Galliumnitrid und andere Gruppe-III-Nitridmaterialien besitzen eine große Bandlücke zwischen dem Valenzband und dem Leitungsband und eignen sich daher sehr gut zum Schalten von hohen Spannungen. Aus diesem Grund sind GaN-HEM-Transistoren sowohl für Anwendungen in der Leistungselektronik als auch für Anwendungen in der Hochfrequenzelektronik hervorragend geeignet.

Man unterscheidet bei Feldeffekttransistoren einschließlich HEM-Transistoren zwischen zwei verschiedenen Grundtypen. Transistoren von Anreicherungstyp werden auch als Normally-off-Transistoren bezeichnet. Charakteristisch für diesen Transistortyp ist, dass sich der Kanal für einen Stromfluss zwischen der Sourceelektrode und der Drainelektrode erst bildet, wenn eine Spannung an die Gateelektrode angelegt wird. Umgekehrt wird bei Transistoren des Verarmungstyps (Normally-on) ein vorhandener Kanal zwischen Sourceelektrode und Drainelektrode durch Anlegen einer Gatespannung abgeschnürt.

Wie oben erwähnt, bildet sich an der Grenze von zwei Halbleitermaterialien mit stark unterschiedlicher Bandlücke ein 2D-Elektronengas, das als leitfähiger Kanal zwischen Sourceelektrode und Drainelektrode dienen kann. Aus diesem Grund ist es relativ einfach, einen HEM-Transistor vom Verarmungstyp herzustellen.

Die Herstellung eines HEM-Transistors vom Anreicherungstyp benötigt hingegen zusätzliche Schritte und zusätzlichen technologischen Aufwand, um das Entstehen des 2D-Eektronengases im Bereich der Gateelektrode ohne Gatepotential zu unterbinden. Ein Ansatz ist ein lokales Rückätzen bzw. Ausdünnen der zweiten Halbleiterschicht unterhalb des metallischen Gatekontakts. Beispiele für diesen Ansatz finden sich in DE 10 2011 000 911 A1, DE 10 2013 102 156 A1, US 8,114,726 B2, US 2010/0219452 A1, US 2011/0073912 A1, US 2013/0237021 A1 und US 2014/0015011 A1. Das lokale Rückätzen der ohnehin dünnen Halbleiterschicht ist allerdings schwierig und erfordert eine sehr exakte Kontrolle des Ätzprozesses.

Ein zweiter Ansatz, der aus heutiger Sicht favorisiert wird, verwendet eine zusätzliche p-dotierte und damit leitfähige Halbleiterschicht zwischen der metallischen Gateelektrode und dem Schichtaufbau, der zur Bildung des 2D-Elektronengases dient. Die p-dotierte Schicht führt zu einer Potentialverschiebung und damit zu einer Unterdrückung des 2DEG-Kanals im Bereich der Gateelektrode. Nachteilig ist hierbei, dass die p-dotierte Schicht außerhalb des Gate-Gebietes vollständig durch Ätzen entfernt werden muss, wobei es aber nicht zur Beschädigung des 2DEG-Kanals dicht unterhalb des Gates durch Überätzen kommen darf. Beispiele für diesen Ansatz finden sich in US 7,728,356 B2, US 8,890,168 B2, US 8,890,206 B2, US 8,933,489 B2, US 2008/0296618 A1 oder WO 2008/151138 A1.

Ein dritter Ansatz verwendet die Implantation von Fluor in die Halbleiterschicht unter der Gateelektrode oder eine Sauerstoff-Plasmabehandlung dieser Schicht vor Aufbringen des Gatedielektrikums. Beispiele für diesen Ansatz finden sich in US 7,932,539 B2, US 2007/0278518 A1 und US 2012/0098599 A1. Nachteil dieses Ansatzes ist fehlende Langzeitstabilität.

Ein vierter Ansatz basiert darauf, die Halbleiterschichten im Bereich zwischen der Sourceelektrode und der Drainelektrode in Streifen zu unterteilen. Bei diesem Ansatz werden in die erste und zweite Halbleiterschicht Gräben geätzt. Zwischen den Gräben verbleiben "Höhenzüge" bzw. Stege, die als Finnen bezeichnet werden. Der Kanal zwischen der Sourceelektrode und der Gateelektrode verläuft in den Finnen und das Gatepotential kann nun auch lateral auf den Kanal einwirken. Es ergeben sich auf diese Weise Potentialverhältnisse, die eine Transistorstruktur vom Anreicherungstyp ermöglichen. Das Ätzen der Gräben ist im Gegensatz zu dem Rückätzen beim erstgenannten Ansatz unkritisch in Bezug auf die Ätztiefe. Nachteilig ist, dass die Leitfähigkeit des Kanals durch die starke Strukturierung beeinträchtigt wird und der elektrische Widerstand im leitfähigen Zustand erhöht ist.

Beispielhaft für eine Transistorstruktur mit Finnen sei auf die Publikation Chandan Yadav et al. "Modeling of GaN-Based Normall-Off FinFET", in IEEE Electron Device Letters, Vol. 35, Nr. 6, Juni 2014, auf die Publikation Ki-Sik Kim et al. "Heterojunction-Free GaN Nanochannel FinFETs With High Performance", IEEE Electron Device Letters, Vol. 34, Nr. 3, März 2013 und auf die Publikation Dong-Hyeok Son et al. "Fabrication of high performance AIGaN/GaN FinFET by utilizing anisotropic wet etchning in TMAH solution", veröffentlicht anlässlich der Solid State Device Research Conference (ESSDERC) vom 14. bis 18. September 2015, Graz, Österreich verwiesen.

DE 10 2015 103 017 A1 offenbart mehrere Ausführungsbeispiele einer Transistorstruktur vom Anreicherungstyp mit Finnen. In einigen Ausführungsbeispielen ist die Länge der Finnen und Gräben kürzer als der Abstand zwischen Sourceelektrode und Drainelektrode. In einem Ausführungsbeispiel gibt es zusätzlich zu den Finnen im Bereich der Gateelektrode eine zweite Gruppe von Finnen, über denen sich die Metallisierung der Sourceelektrode erstreckt. In allen Ausführungsbeispielen ist zwischen der Gateelektrode und dem Schichtaufbau der Finnen ein p-dotiertes Material angeordnet. Somit kombiniert DE 10 2015 103 017 A1 den zweiten und vierten Ansatz.

Vor diesem Hintergrund ist es eine Aufgabe der vorliegenden Erfindung, ein Halbleiterbauelement der eingangs genannten Art anzugeben, das die oben genannten Nachteile vermeidet oder zumindest reduziert. Es ist insbesondere eine Aufgabe der Erfindung, ein Halbleiterbauelement mit einer Transistorstruktur vom Anreicherungstyp anzugeben, welches mit reduziertem lithografischen Aufwand und/oder höherer Ausbeute und somit kostengünstiger hergestellt werden kann.

Gemäß einem Aspekt der vorliegenden Erfindung wird diese Aufgabe durch ein Halbleiterbauelement nach dem Anspruch 1 gelöst, bei dem insbesondere die Löcher mit den Gatefingern eine erste Lochreihe und - zumindest - eine zweite Lochreihe bilden, wobei die erste und die zweite Lochreihe jeweils quer zu der zweiten Richtung verlaufen und somit eine dritte Richtung definieren, und wobei die Löcher der zweiten Lochreihe in der zweiten Richtung und in der dritten Richtung relativ zu den Löchern der ersten Lochreihe versetzt sind.

Die neue Transistorstruktur verwendet einen Schichtaufbau, der im Bereich der Gateelektrode durch Löcher und Finnen strukturiert ist, um den durch den Schichtaufbau gebildeten 2DEG-Kanal zu unterdrücken und eine Transistorstruktur vom Anreicherungstyp zu erhalten. Da die Gatefinger der Gateelektrode in den Schichtaufbau hineingreifen, verändern sich die Potentialverhältnisse und es bildet sich eine Verarmungszone um die Gatefinger herum. Die Verarmungszone stört die Bildung des 2D-Elektronengases. In den bevorzugten Ausführungsbeispielen sind die Löcher mit den Gatefingern mit relativen Abständen voneinander angeordnet, die so gewählt sind, dass der Kanal zwischen Sourceelektrode und Drainelektrode ohne angelegtes Gatepotential abgeschnürt ist.

Im Unterschied zu den Finnen-Transistoren aus dem Stand der Technik besitzt das neue Halbleiterbauelement zumindest zwei Lochreihen mit Gatefingern, wobei die Löcher der Lochreihen so gegeneinander versetzt sind, dass die verbleibenden Finnen in der zweiten Richtung nicht mehr geradlinig durchlaufen, sondern unterbrochen oder zumindest eingeschnürt/verengt sind. Zugleich bilden die versetzten Löcher der zweiten Lochreihe aber weitere Finnen, die relativ zu den Finnen der ersten Lochreihe versetzt sind. Diese Art der Strukturierung ermöglicht eine im Vergleich zum Stand der Technik geringere Löcher- oder Grabendichte und damit breitere Finnen. Die geringere Löcherdichte führt zu einem geringeren Aufwand bei der Strukturierung und ermöglicht eine kostengünstigere Realisierung. Die aufgrund der größeren Lochabstände breiteren Finnen ermöglichen zudem einen geringeren elektrischen Widerstand im leitenden bzw. angereicherten Zustand. Ein weiterer Vorteil liegt in der unkritischen Ätzung der Löcher durch das 2D-Elektronengas hindurch, womit sich eine verbesserte Reproduzierbarkeit und eine höhere Ausbeute in der Fertigung ergeben. Die oben genannte Aufgabe ist daher vollständig gelöst.

In einer bevorzugten Ausgestaltung verlaufen die erste und die zweite Lochreihe parallel zueinander.

Prinzipiell ist es möglich, dass die erste und die zweite Lochreihe schräg zueinander verlaufen und beispielsweise einen Winkel von 10° einschließen. Die bevorzugte Ausgestaltung besitzt demgegenüber den Vorteil, dass die Löcher mit den Gatefingern und die Finnen in einem möglichst kleinen Bereich unterhalb der Gateelektrode gleichmäßig voneinander beabstandet und angeordnet sind. Vorteilhaft können mit dieser Ausgestaltung homogene Kanaleigenschaften über die Kanalbreite in der dritten Richtung erreicht werden.

In einer weiteren Ausgestaltung bilden die Löcher eine dritte Lochreihe, wobei die Löcher der dritten Lochreihe in der zweiten Richtung und in der dritten Richtung relativ zu den Löchern der zweiten Lochreihe versetzt sind. Vorzugsweise sind die Löcher der ersten Lochreihe und der dritten Lochreihe in der zweiten Richtung zueinander ausgerichtet, so dass die Löcher der ersten Lochreihe und der dritten Lochreihe weitere Lochreihen in der zweiten Richtung bilden. Des Weiteren bilden die Löcher in bevorzugten Ausführungsbeispielen Lochreihen, die schräg zu der zweiten und der dritten Richtung verlaufen.

Diese Ausgestaltung ermöglicht eine besonders einfache Strukturierung der ersten und zweiten Halbleiterschichten. Die relativen Abstände der Gatefinger voneinander können nochmals erhöht und die Lochdichte weiter reduziert werden.

In einer weiteren Ausgestaltung sind die Finnen zwischen den Löchern der ersten Lochreihe und die Finnen zwischen den Löchern der zweiten Lochreihe in der dritten Richtung jeweils um eine Distanz versetzt, die der Hälfte der Summe aus Lochdurchmesser und Lochabstand in der dritten Richtung entspricht. In bevorzugten Ausführungsbeispielen sind der Lochdurchmesser und der Lochabstand in der dritten Richtung zudem gleich.

In den bevorzugten Ausführungsbeispielen dieser Ausgestaltung sind die Löcher der zweiten Lochreihe in der dritten Richtung praktisch mittig zwischen jeweils zwei Löchern der ersten Lochreihe angeordnet. Diese Ausgestaltung trägt vorteilhaft zu einer Minimierung der Lochdichte und zu einer Reduzierung des Lithografieaufwandes bei. Außerdem ermöglicht diese Ausgestaltung eine sehr gleichmäßige Feldwirkung der Gateelektrode auf das 2D-Elektronengas. Generell besitzt diese Ausgestaltung den Vorteil, dass die Lochabstände benachbarter Löcher relativ groß gewählt werden können.

In einer weiteren vorteilhaften Ausgestaltung ist ein erster Lochabstand zwischen zwei benachbarten Löchern der ersten Lochreihe gleich einem zweiten Lochabstand zwischen zwei benachbarten Löchern der zweiten Lochreihe. Des Weiteren ist es bevorzugt, dass ein weiterer Lochabstand zwischen einem Loch der ersten Lochreihe und einem benachbarten Loch der zweiten Lochreihe gleich dem ersten Lochabstand zwischen zwei benachbarten Löchern der ersten Lochreihe ist.

Diese Ausgestaltungen tragen ebenfalls zu einer sehr gleichmäßigen Feldwirkung der Gateelektrode auf das 2D-Elektronengas bei, während sie die Strukturierung der ersten und zweiten Halbleiterschicht vereinfachen.

In einer weiteren Ausgestaltung liegt der Lochabstand zwischen benachbarten Löchern im Bereich von 50 nm bis 150 nm, vorzugsweise im Bereich bis 100 nm. Gemäß einer weiteren vorteilhaften Ausgestaltung besitzen die Löcher in der zweiten Richtung einen Lochdurchmesser, der im Bereich von 50 nm bis 150 nm liegt, vorzugsweise im Bereich bis 100 nm.

Lochabstände und Lochdurchmesser in dieser Größenordnung haben sich in Untersuchungen der neuen Transistorstruktur als vorteilhaft für eine besonders kostengünstige Realisierung eines HEM-Transistors vom Anreicherungstyp herausgestellt.

In einer weiteren Ausgestaltung bilden die Löcher im Bereich der Gateelektrode eine kumulierte Lochquerschnittsfläche und die Finnen bilden im Bereich der Gateelektrode eine kumulierte Finnenquerschnittsfläche, wobei die kumulierte Lochquerschnittsfläche und die kumulierte Finnenquerschnittsfläche in etwa gleich groß sind. "In etwa gleich groß" bedeutet hier, dass die Finnenquerschnittsfläche zwischen 40 % und 60 % der Fläche unter der Gateelektrode einnimmt, und vorzugsweise im Bereich von etwa 50 % der Gesamtfläche unter der Gateelektrode beträgt.

Die kumulierte Lochquerschnittsfläche ist die Summe der Lochquerschnitte im Bereich der Gateelektrode. Die kumulierte Finnenquerschnittsfläche ist die Gesamtfläche der verbleibenden Finnen im Bereich der Gateelektrode. In der bevorzugten Ausgestaltung sind die Löcher groß genug, um das Metall der Gateelektrode und - in bevorzugten Ausführungsbeispielen - ein isolierendes Dielektrikum einzubringen. Andererseits sind die verbleibenden Finnen groß genug, um eine effektive Stromleitung im eingeschalteten (angereicherten) Zustand des Transistors zu ermöglichen.

In einer weiteren Ausgestaltung sind die Löcher mit einem elektrisch isolierenden Dielektrikum ausgeleidet. Vorzugsweise sind die Löcher vollständig mit dem isolierenden Dielektrikum ausgekleidet.

In dieser Ausgestaltung sind die metallischen Gatefinger der Gateelektrode durch das Dielektrikum von dem Gruppe-III-Nitridmaterial der ersten und zweiten Halbleiterschicht getrennt. Vorteilhaft verzichtet diese Ausgestaltung in bevorzugten Ausführungsbeispielen auf ein zusätzliches p-dotiertes Material, welches bei Transistorstrukturen nach dem Stand der Technik häufig eine leitfähige Verbindung zwischen der Gateelektrode und ausgewählten Abschnitten des Kanalmaterials bereitstellt. Die Ausgestaltung ermöglicht eine besonders kostengünstige Realisierung und eine Maximierung der Lochabstände. Sie trägt ferner dazu bei, hohe Durchbruchfeldstärken für Anwendungen in der Leistungselektronik zu ermöglichen.

In einer weiteren Ausgestaltung sind Finnen in der dritten Richtung jeweils von zwei isolierten Gatefingern seitlich begrenzt.

In dieser Ausgestaltung ist links und rechts von jeder Finne jeweils ein Gatefinger angeordnet. Alternativ hierzu ist es in anderen Ausgestaltungen möglich, ausgewählte Finnen seitlich mit einem p-dotierten oder n-dotierten Material zu begrenzen und/oder leitfähige Verbindungen zur Sourceelektrode oder Drainelektrode zu realisieren. Die bevorzugte Ausgestaltung trägt zu einer besonders einfachen und kostengünstigen Realisierung des neuen Halbleiterbauelements bei.

In einer weiteren Ausgestaltung sind die Löcher - zumindest annähernd - kreisförmig.

Diese Ausgestaltung ist besonders vorteilhaft, wenn die Löcher mithilfe einer Elektronenstrahllithografie erzeugt werden. Weitgehend kreisförmige (kreiszylindrische) Löcher können in den bevorzugten geringen Abmessungen leichter hergestellt werden. In einigen Ausgestaltungen können die Lochreihen alternativ oder ergänzend mithilfe der sogenannten Nano-Imprint-Lithografie (NIL) erzeugt werden. Dabei wird ein strukturierter Stempel verwendet, um die Strukturierung des Fotolacks für den Lithografieprozess zu erzeugen. In einigen bevorzugten Ausführungsbeispielen mit dieser Variante sind verschiedene Lochquerschnitte einschließlich nicht-kreisförmiger Lochquerschnitte möglich.

In allen bevorzugten Ausgestaltungen besitzt das neue Halbleiterbauelement den Vorteil, dass das 2D-Elektronengas nur dort durch Gatefinger unterbrochen wird, wo die Feldwirkung der Gateelektrode effektiv benötigt wird. Dementsprechend besitzt das Halbleiterbauelement in bevorzugten Ausführungsbeispielen nur im Bereich der Gateelektrode Löcher, die sich durch die dichte Anordnung und die verbleibenden Materialstege wie Finnen auswirken, zugleich aber den Kanalwiderstand im eingeschalteten Zustand weniger stark erhöhen.. Der verbleibende Kanalbereich zwischen der Sourceelektrode und der Gateelektrode ist in bevorzugten Ausführungsbeispielen "lochfrei", also nicht in der beschriebene Weise strukturiert. In einigen Ausführungsbeispielen ist der nichtstrukturierte Kanalbereich in der zweiten Richtung mehr als doppelt so groß wie der durch Löcher und Finnen strukturierte Bereich.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Figur 1: eine vereinfachte Darstellung eines Ausführungsbeispiels des neuen Halbleiterbauelements in einer Ansicht von oben,
- Figur 2: einen Schnitt durch das Halbleiterbauelement aus Fig. 1 entlang der Linie I, und
- Figur 3: einen Schnitt durch das Halbleiterbauelement aus Fig. 1 entlang der Linie II.

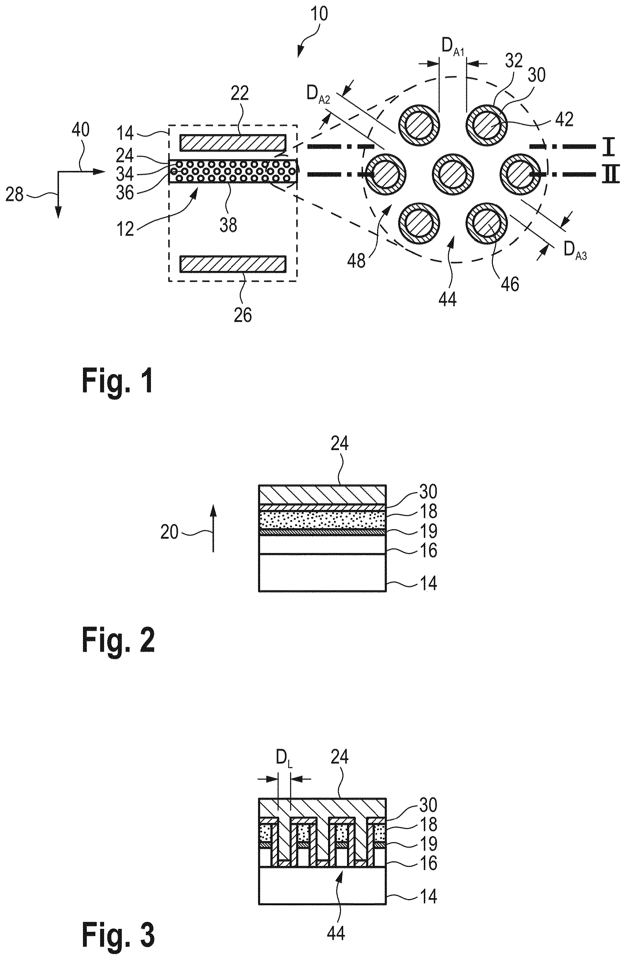

In Fig. 1 ist ein Ausführungsbeispiel des neuen Halbleiterbauelements in seiner Gesamtheit mit der Bezugsziffer 10 bezeichnet. Das Halbleiterbauelement beinhaltet eine Transistorstruktur 12, die auf einem Basissubstrat 14 aufgebaut ist. Wie anhand Fig. 2 schematisch dargestellt ist, ist auf dem Basissubstrat 14 ein Schichtaufbau mit einer ersten Halbleiterschicht 16 und einer zweiten Halbleiterschicht 18 angeordnet.

Die erste Halbleiterschicht 16 ist mit einem Gruppe-III-Nitridmaterial hergestellt und kann beispielsweise eine GaN-Schicht sein, die epitaktisch auf das Basissubstrat 14 aufgewachsen ist. Die zweite Halbleiterschicht 18 ist ein Gruppe-III-Nitridmaterial, das sich von dem Gruppe-III-Nitridmaterial der ersten Halbleiterschicht 16 unterscheidet. Beispielsweise ist die zweite Halbleiterschicht 18 mit einem AlGaN-Material hergestellt, das epitaktisch auf die erste Halbleiterschicht 16 aufgewachsen ist. Optional kann in einigen bevorzugten Ausführungsbeispielen eine dritte Schicht (hier nicht dargestellt) zwischen der zweiten Halbleiterschicht 18 und der ersten Halbleiterschicht 16 angeordnet sein, wobei die dritte Schicht vorteilhaft zur Anpassung der ersten und zweiten Halbleiterschicht dient bzw. den Übergang von der ersten zur zweiten Halbleiterschicht "glättet". Beispielsweise kann die Anpassungsschicht für die oben genannte Materialkombination aus Aluminiumnitrid (AIN) hergestellt sein.

Wie bereits eingangs erwähnt, können prinzipiell auch andere Verbundhalbleiter mit Nitrid und einem Gruppe-III-Material verwendet werden. Das Gruppe-III-Nitridmaterial der ersten Halbleiterschicht 16 und das Gruppe-III-Nitridmaterial der zweiten Halbleiterschicht 18 besitzen unterschiedliche Ferminiveaus bzw. unterschiedliche Bandlücken. Infolgedessen bildet sich im Grenzbereich der Halbleiterschichten 16, 18 ein 2D-Elektronengas 19, d.h. eine Schicht mit einer Vielzahl von "freien" Elektronen, die sich in dem Grenzbereich in zwei lateralen Dimensionen bewegen können. Wie in Fig. 2 anhand des Pfeils 20 dargestellt, definiert der Schichtaufbau eine erste Richtung und die Beweglichkeit der Elektronen im Grenzbereich der Halbleiterschichten 16, 18 ist im Wesentlichen orthogonal zu der ersten Richtung 20.

Bezug nehmend auf Fig. 1 besitzt das Halbleiterbauelement eine Sourceelektrode 22, eine Gateelektrode 24 und eine Drainelektrode 26, die entlang einer zweiten Richtung 28 angeordnet und voneinander beabstandet sind. Typischerweise sind die Elektroden aus einem metallischen Material hergestellt, das auf dem Halbleiter-Schichtaufbau abgelagert wird. Fig. 2 zeigt die Metallschicht der Gateelektrode 24 über einem isolierenden Dielektrikum 30. Das Dielektrikum 30 kann beispielsweise eine Oxidschicht sein, die auf der zweiten Halbleiterschicht 18 gebildet ist.

Bezug nehmend auf die Fig. 1 und 3 sind im Bereich der Gateelektrode 24 eine Vielzahl von Löchern 32 geätzt. Die Löcher 32 erstrecken sich entlang der ersten Richtung 20 in die Tiefe des Schichtaufbaus mit der ersten und der zweiten Halbleiterschicht 16, 18. In den bevorzugten Ausführungsbeispielen sind die Löcher 32 durch lokales Rückätzen der Gruppe-III-Nitridmaterialien hergestellt. Die Tiefe der Löcher 32 ist bevorzugt größer als die Höhe des Schichtaufbaus mit den zwei Gruppe-III-Nitridmaterialien. In einigen Ausführungsbeispielen kann die Tiefe der Löcher 32 beispielsweise größer als 30 nm sein, während der Schichtaufbau mit den Gruppe-III-Nitridmaterialien eine Höhe von etwa 30 nm besitzt. Generell können die Löcher 32 somit in der Richtung 20 eine Tiefe aufweisen, die bis auf das Basissubstrat 14 oder sogar in das Basissubstrat 14 hinein reicht.

Wie man in Fig. 1 erkennen kann, sind die Löcher 32 hier in zueinander parallelen Lochreihen 34, 36, 38 angeordnet, die sich in einer dritten Richtung 40 quer zu der zweiten Richtung 28 erstrecken. In bevorzugten Ausführungsbeispielen verlaufen die Lochreihen 34, 36, 38 orthogonal zu der zweiten Richtung 28 und bevorzugt orthogonal zu der ersten Richtung 20.

Wie man in Fig. 3 erkennen kann, sind die Löcher 32 hier jeweils mit dem isolierenden Dielektrikum 30 ausgekleidet. In den bevorzugten Ausführungsbeispielen wird das Dielektrikum 30 auf der zweiten Halbleiterschicht 18 gebildet, nachdem die Löcher 32 durch einen Ätzprozess hergestellt wurden. In einem späteren Schritt werden die Metallschichten der Elektroden 22, 24, 26 aufgebracht. Mit diesem späteren Schritt werden die Löcher 32 mit dem metallischen Material der Gateelektrode 24 gefüllt, so dass metallische Gatefinger 42 entstehen, die in die Löcher 32 hineinreichen. Bevorzugt füllen die Gatefinger 42 zusammen mit dem Dielektrikum 30 die Löcher 32 vollständig aus. Der zwischen den Löchern 32 verbleibende Schichtaufbau mit der ersten und zweiten Halbleiterschicht 16, 18 und dem 2D-Elektronengas 19 bildet Stege bzw. Finnen, in denen ein Stromfluss von der Sourceelektrode 22 zur Gateelektrode 26 möglich ist.

Im Unterschied zu Transistorstrukturen mit Finnen nach dem Stand der Technik laufen die Finnen 44 hier in der zweiten Richtung 28 nicht gerade zur Drainelektrode durch, weil die Löcher der zweiten Lochreihe 34 in der dritten Richtung 40 relativ zu den Löchern der ersten Lochreihe 34 und relativ zu den Löchern der dritten Lochreihe 38 versetzt sind, wie dies in Fig. 1 dargestellt ist.

Die Löcher 32 sind in den bevorzugten Ausführungsbeispielen im Durchmesser gerade groß genug, um das relativ dünne Dielektrikum 30 und das Metall der Gateelektrode 24 einbringen zu können. Da die Löcher 32 im leitenden (angereicherten) Zustand der Transistorstruktur 12 den Stromfluss von der Sourceelektrode 22 zur Drainelektrode 26 blockieren und somit den Widerstand Rₒₙ erhöhen, ist es wünschenswert, die Löcher 32 möglichst klein machen. In den bevorzugten Ausführungsbeispielen hat sich ein Lochdurchmesser D_{L} als vorteilhaft erwiesen, der im Bereich von 50 nm bis 100 nm liegt. In den bevorzugten Ausführungsbeispielen liegt der Lochabstand L_{A1} zwischen zwei benachbarten Löchern einer Lochreihe ebenfalls zwischen 50 nm und 100 nm. Des Weiteren liegt auch der Lochabstand D_{A2} zwischen zwei benachbarten Löchern verschiedener Lochreihen in den bevorzugten Ausführungsbeispielen im Bereich zwischen 50 nm und 100 nm. In den bevorzugten Ausführungsbeispielen sind die Lochabstände D_{A1} und D_{A2} (im Rahmen der Fertigungstoleranzen) gleich.

In dem hier dargestellten Ausführungsbeispiel besitzen die Löcher 32 einen weitgehend kreisförmigen Querschnitt, wobei eine mathematisch exakte Kreisform aufgrund von Fertigungstoleranzen und Prozessinstabilitäten selten erreicht wird. In anderen Ausführungsbeispielen (hier nicht dargestellt) können die Löcher 32 einen anderen Querschnitt aufweisen, beispielsweise länglich oval, quadratisch, sechseckig, achteckig, rechteckig oder mit einer anderen Querschnittsform, die sogar unregelmäßig ausfallen kann. In den obengenannten Ausführungsbeispielen ist der Lochdurchmesser D_{L} vorzugsweise in der dritten Richtung 40 gemessen. In der zweiten Richtung 28 kann der Lochdurchmesser größer oder kleiner sein. Bevorzugt ist er in der zweiten Richtung 28 in etwa gleich wie in der dritten Richtung 40.

Die Summe der Lochquerschnittsflächen im Bereich der Gateelektrode 24 ist in den bevorzugten Ausführungsbeispielen in etwa gleich der Summe der verbleibenden Finnenquerschnittsflächen 48. Außerdem beschränkt sich die Strukturierung des Schichtaufbaus durch die Löcher 32 und Finnen 44 in den bevorzugten Ausführungsbeispielen auf den Bereich unterhalb der Gateelektrode 24, wie dies in Fig. 1 dargestellt ist. Abseits der Gateelektrode 24 ist der Kanalbereich zwischen der Sourceelektrode 22 und der Drainelektrode 26 vorzugsweise unstrukturiert, um einen weitgehend ungestörten Stromfluss zwischen Sourceelektrode 22 und Drainelektrode 26 zu begünstigen.

## Patentansprüche

1. Halbleiterbauelement mit einer Transistorstruktur (12) vom Anreicherungstyp, wobei die Transistorstruktur (12) einen Schichtaufbau besitzt, der ein Basissubstrat (14), eine erste Halbleiterschicht (16) und eine zweite Halbleiterschicht (18) aufweist, die entlang einer ersten Richtung (20) übereinander angeordnet sind, wobei die Transistorstruktur (12) ferner eine Sourceelektrode (22), eine Gateelektrode (24) und eine Drainelektrode (26) besitzt, die entlang einer zweiten Richtung (28) voneinander beabstandet sind, wobei die erste Halbleiterschicht (16) durch ein erstes Gruppe-III-Nitridmaterial gebildet wird, das auf dem Basissubstrat (14) angeordnet ist, wobei die zweite Halbleiterschicht (18) durch ein zweites Gruppe-III-Nitridmaterial gebildet wird, das auf der ersten Schicht (16) angeordnet ist, wobei das erste und das zweite Gruppe-III-Nitridmaterial verschieden voneinander sind, sodass sich im Grenzbereich der ersten und zweiten Halbleiterschicht (16, 18) ein 2D-Elektronengas (19) bildet, wobei die erste Halbleiterschicht (16) und die zweite Halbleiterschicht (18) im Bereich der Gateelektrode (24) eine Vielzahl von Löchern (32) aufweisen, zwischen denen eine Vielzahl von Finnen (44) mit dem ersten und dem zweiten Gruppe-III-Nitridmaterial verbleiben, und wobei die Gateelektrode (24) eine Vielzahl von Gatefingern (42) besitzt, die in die Löcher (32) hineinreichen, wobei die Löcher (32) mit den Gatefingern (42) eine erste Lochreihe (34) und eine zweite Lochreihe (36) bilden, die jeweils quer zu der zweiten Richtung (28) verlaufen und somit eine dritte Richtung (40) definieren, wobei die Löcher (32) der zweiten Lochreihe (36) in der zweiten Richtung (28) relativ zu den Löchern (32) der ersten Lochreihe (34) versetzt sind, **dadurch gekennzeichnet, dass** die Löcher (32) der zweiten Lochreihe (36) ferner in der dritten Richtung (40) relativ zu den Löchern (32) der ersten Lochreihe (34) versetzt sind.

2. Halbleiterbauelement nach Anspruch 1, **dadurch gekennzeichnet, dass** die erste und die zweite Lochreihe (34, 36) parallel zueinander verlaufen.

3. Halbleiterbauelement nach Anspruch 1 oder 2, **dadurch gekennzeichnet, dass** die Löcher (32) eine dritte Lochreihe (38) bilden, wobei die Löcher (32) der dritten Lochreihe (38) in der zweiten Richtung (28) und in der dritten Richtung (40) relativ zu den Löchern (32) der zweiten Lochreihe (36) versetzt sind.

4. Halbleiterbauelement nach einem der Ansprüche 1 bis 3, **dadurch gekennzeichnet, dass** die Finnen (44) zwischen den Löchern (32) der ersten Lochreihe (34) und die Finnen (44) zwischen den Löchern (32) der zweiten Lochreihe (36) in der dritten Richtung (40) jeweils um eine Distanz versetzt sind, die der Hälfte der Summe aus Lochdurchmesser (D_{L}) und Lochabstand (D_{A1}) in der dritten Richtung entspricht.

5. Halbleiterbauelement nach einem der Ansprüche 1 bis 4, **dadurch gekennzeichnet, dass** ein erster Lochabstand (D_{A1}) zwischen zwei benachbarten Löchern (32) der ersten Lochreihe (34) gleich einem zweiten Lochabstand zwischen zwei benachbarten Löchern (32) der zweiten Lochreihe (36) ist.

6. Halbleiterbauelement nach einem der Ansprüche 1 bis 5, **dadurch gekennzeichnet, dass** ein weiterer Lochabstand (D_{A2}) zwischen einem Loch (32) der ersten Lochreihe (34) und einem benachbarten Loch (32) der zweiten Lochreihe (36) gleich dem ersten Lochabstand (D_{A1}) zwischen zwei benachbarten Löchern (32) der ersten Lochreihe (34) ist.

7. Halbleiterbauelement nach einem der Ansprüche 1 bis 6, **dadurch gekennzeichnet, dass** der Lochabstand (D_{A1}, D_{A2}, D_{A3}) zwischen benachbarten Löchern im Bereich von 50 nm bis 150 nm, vorzugsweise im Bereich bis 100nm liegt.

8. Halbleiterbauelement nach einem der Ansprüche 1 bis 7, **dadurch gekennzeichnet, dass** die Löcher (32) in der dritten Richtung einen Lochdurchmesser (D_{L}) besitzen, der im Bereich von 50 nm bis 150 nm, vorzugsweise im Bereich bis 100nm liegt.

9. Halbleiterbauelement nach einem der Ansprüche 1 bis 8, **dadurch gekennzeichnet, dass** die Löcher (32) im Bereich der Gateelektrode (24) eine kumulierte Lochquerschnittsfläche (46) bilden und dass die Finnen (44) im Bereich der Gateelektrode (24) eine kumulierte Finnenquerschnittsfläche (48) bilden, wobei die kumulierte Lochquerschnittsfläche (46) und die kumulierte Finnenquerschnittsfläche (48) in etwa gleich groß sind.

10. Halbleiterbauelement nach einem der Ansprüche 1 bis 9, **dadurch gekennzeichnet, dass** die Löcher (32) mit einem elektrisch isolierenden Dielektrikum (30) ausgekleidet sind.

11. Halbleiterbauelement nach einem der Ansprüche 1 bis 10, **dadurch gekennzeichnet, dass** die Finnen (44) in der dritten Richtung jeweils von zwei isolierten Gatefingern (42) seitlich begrenzt werden.

12. Halbleiterbauelement nach einem der Ansprüche 1 bis 11, **dadurch gekennzeichnet, dass** die Löcher (32) kreisförmig sind.

## Claims

1. A semiconductor element comprising an enhancement-type transistor structure (12), wherein the transistor structure (12) has a layer construction comprising a base substrate (14), a first semiconductor layer (16) and a second semiconductor layer (18), which are arranged one above another along a first direction (20), wherein the transistor structure (12) further has a source electrode (22), a gate electrode (24) and a drain electrode (26), which are spaced apart from one another along a second direction (28), wherein the first semiconductor layer (16) is formed by a first group III nitride material arranged on the base substrate (14), wherein the second semiconductor layer (18) is formed by a second group III nitride material arranged on the first layer (16), wherein the first and second group III nitride materials differ from one another, such that a 2D electron gas (19) forms in a boundary region of the first and second semiconductor layers (16, 18), wherein the first semiconductor layer (16) and the second semiconductor layer (18) have a plurality of holes (32) in the region of the gate electrode (24), between which holes a plurality of fins (44) comprising the first and second group III nitride materials remain, and wherein the gate electrode (24) has a plurality of gate fingers (42) extending into the holes (32), wherein the holes (32) with the gate fingers (42) form a first row of holes (34) and a second row of holes (36), which rows of holes each run transversely with respect to the second direction (28) and thus define a third direction (40), wherein the holes (32) of the second row of holes (36) are offset relative to the holes (32) of the first row of holes (34) in the second direction (28), **characterized in that** the holes (32) of the second row of holes (36) further are offset relative to the holes (32) of the first row of holes (34) in the third direction (40).

2. The semiconductor element of claim 1, **characterized in that** the first and second rows of holes (34, 36) run parallel to one another.

3. The semiconductor element of claim 1 or 2, **characterized in that** the holes (32) form a third row of holes (38), wherein the holes (32) of the third row of holes (38) are offset relative to the holes (32) of the second row of holes (36) in the second direction (28) and in the third direction (40).

4. The semiconductor element of any of claims 1 to 3, **characterized in that** the fins (44) between the holes (32) of the first row of holes (34) and the fins (44) between the holes (32) of the second row of holes (36) are offset in the third direction (40) in each case by a distance corresponding to half of the sum of hole diameter (D_{L}) and hole distance (D_{A1}) in the third direction.

5. The semiconductor element of any of claims 1 to 4, **characterized in that** a first hole distance (D_{A1}) between two adjacent holes (32) of the first row of holes (34) is equal to a second hole distance between two adjacent holes (32) of the second row of holes (36).

6. The semiconductor element of any of claims 1 to 5, **characterized in that** a further hole distance (D_{A2}) between a hole (32) of the first row of holes (34) and an adjacent hole (32) of the second row of holes (36) is equal to the first hole distance (D_{A1}) between two adjacent holes (32) of the first row of holes (34).

7. The semiconductor element of any of claims 1 to 6, **characterized in that** the hole distance (D_{A1}, D_{A2}, D_{A3}) between adjacent holes is in the range of 50 nm to 150 nm, preferably in a range up to 100 nm.

8. The semiconductor element of any of claims 1 to 7, **characterized in that** the holes (32) have in the third direction a hole diameter (D_{L}) which is in the range of 50 nm to 150 nm, preferably in a range up to 100 nm.

9. The semiconductor element of any of claims 1 to 8, **characterized in that** the holes (32) in the region of the gate electrode (24) form a cumulated hole cross-sectional area (46) and **in that** the fins (44) in the region of the gate electrode (24) form a cumulated fin cross-sectional area (48), wherein the cumulated hole cross-sectional area (46) and the cumulated fin cross-sectional area (48) are approximately equal in magnitude.

10. The semiconductor element of any of claims 1 to 9, **characterized in that** the holes (32) are lined with an electrically insulating dielectric (30).

11. The semiconductor element of any of claims 1 to 10, **characterized in that** the fins (44) are laterally bounded in each case by two insulated gate fingers (42) in the third direction.

12. The semiconductor element of any of claims 1 to 11, **characterized in that** the holes (32) are circular.

## Revendications

1. Composant à semi-conducteur doté d'une structure de transistor (12) du type à enrichissement, la structure de transistor (12) possédant une structure en couches qui présente un substrat de base (14), une première couche semi-conductrice (16) et une deuxième couche semi-conductrice (18) qui sont disposées l'une sur l'autre le long d'une première direction (20), la structure de transistor (12) possédant en outre une électrode de source (22), une électrode de grille (24) et une électrode de drain (26) qui sont espacées les unes des autres le long d'une deuxième direction (28), la première couche semi-conductrice (16) étant formée par un premier matériau de nitrure du groupe III qui est disposé sur le substrat de base (14), la deuxième couche semi-conductrice (18) étant formée par un deuxième matériau de nitrure du groupe III qui est disposé sur la première couche (16), le premier et le deuxième matériau de nitrure du groupe III étant différents l'un de l'autre de sorte qu'un gaz d'électrons 2D (19) se forme dans la zone limite de la première et de la deuxième couche semi-conductrice (16, 18), la première couche semi-conductrice (16) et la deuxième couche semi-conductrice (18) présentant dans la zone de l'électrode de grille (24) une pluralité de trous (32) entre lesquels reste une pluralité d'ailettes (44) avec le premier et le deuxième matériau de nitrure du groupe III, et l'électrode de grille (24) possédant une pluralité de doigts de grille (42) qui pénètrent dans les trous (32), les trous (32) formant avec les doigts de grille (42) une première rangée de trous (34) et une deuxième rangées de trous (36) qui s'étendent respectivement transversalement à la deuxième direction (28) et définissent ainsi une troisième direction (40), les trous (32) de la deuxième rangée de trous (36) étant décalés dans la deuxième direction (28) par rapport aux trous (32) de la première rangée de trous (34),
**caractérisé en ce que** les trous (32) de la deuxième rangée de trous (36) sont en outre décalés dans la troisième direction (40) par rapport aux trous (32) de la première rangée de trous (34).

2. Composant à semi-conducteur selon la revendication 1, **caractérisé en ce que** la première et la deuxième rangée de trous (34, 36) s'étendent en parallèle l'une à l'autre.

3. Composant à semi-conducteur selon la revendication 1 ou 2, **caractérisé en ce que** les trous (32) forment une troisième rangée de trous (38), les trous (32) de la troisième rangée de trous (38) étant décalés dans la deuxième direction (28) et dans la troisième direction (40) par rapport aux trous (32) de la deuxième rangée de trous (36).

4. Composant à semi-conducteur selon l'une quelconque des revendications 1 à 3, **caractérisé en ce que** les ailettes (44) entre les trous (32) de la première rangée de trous (34) et les ailettes (44) entre les trous (32) de la deuxième rangée de trous (36) sont décalées dans la troisième direction (40) respectivement d'une distance qui correspond à la moitié de la somme du diamètre de trou (D_{L}) et de l'écartement des trous (D_{A1}) dans la troisième direction.

5. Composant à semi-conducteur selon l'une quelconque des revendications 1 à 4, **caractérisé en ce qu'**un premier écartement des trous (D_{A1}) entre deux trous voisins (32) de la première rangée de trous (34) est égal à un deuxième écartement des trous entre deux trous voisins (32) de la deuxième rangée de trous (36).

6. Composant à semi-conducteur selon l'une quelconque des revendications 1 à 5, **caractérisé en ce qu'**un autre écartement des trous (D_{A2}) entre un trou (32) de la première rangée de trous (34) et un trou voisin (32) de la deuxième rangée de trous (36) est égal au premier écartement des trous (D_{A1}) entre deux trous voisins (32) de la première rangée de trous (34).

7. Composant à semi-conducteur selon l'une quelconque des revendications 1 à 6, **caractérisé en ce que** l'écartement des trous (D_{A1}, D_{A2}, D_{A3}) entre des trous voisins se situe dans la plage de 50 nm à 150 nm, de préférence dans la plage jusqu'à 100 nm.

8. Composant à semi-conducteur selon l'une quelconque des revendications 1 à 7, **caractérisé en ce que** les trous (32) dans la troisième direction possèdent un diamètre de trou (D_{L}) qui se situe dans la plage de 50 nm à 150 nm, de préférence dans la plage jusqu'à 100 nm.

9. Composant à semi-conducteur selon l'une quelconque des revendications 1 à 8, **caractérisé en ce que** les trous (32) dans la zone de l'électrode de grille (24) forment une superficie de la section de trou cumulée (46), et **en ce que** les ailettes (44) dans la zone de l'électrode de grille (24) forment une superficie de la section d'ailette cumulée (48), la superficie de la section de trou cumulée (46) et la superficie de la section d'ailette cumulée (48) étant approximativement égales.

10. Composant à semi-conducteur selon l'une quelconque des revendications 1 à 9, **caractérisé en ce que** les trous (32) sont revêtus d'un diélectrique (30) électriquement isolant.

11. Composant à semi-conducteur selon l'une quelconque des revendications 1 à 10, **caractérisé en ce que** les ailettes (44) dans la troisième direction sont respectivement limitées latéralement par deux doigts de grille (42) isolés.

12. Composant à semi-conducteur selon l'une quelconque des revendications 1 à 11, **caractérisé en ce que** les trous (32) sont circulaires.
